# EUROPÄISCHE PATENTANMELDUNG

(11) **EP 3 686 615 A1**
(43) Veröffentlichungstag der Anmeldung: **29.07.2020**
(21) Anmeldenummer: 19153491.6
(22) Anmeldetag: 24.01.2019
(51) Int. Cl.: G01R 31/08, H02H 7/26, G01R 19/25, H02H 3/04, H02H 3/08, H02H 3/087, H02J 3/36

(54) **INTEGRIERTER ODER MODULAR AUFGEBAUTER KONTROLLER FÜR EINEN OPTIMIERTEN STROMNETZBETRIEB EINES AUS EINEM WECHSELSPANNUNGS- ODER GLEICHSPANNUNGSNETZ GENERIERTEN GLEICHSPANNUNGSNETZES ODER HYBRIDNETZES, SEINE ANWENDUNGEN SOWIE EIN VERFAHREN FÜR EINEN OPTIMIERTEN STROMNETZBETRIEB**

(71) Anmelder: Siemens Aktiengesellschaft, 80333 München (DE)
(72) Erfinder: Beckert, Thomas, 90461 Nürnberg (DE); Nannen, Hauke, 90443 Nürnberg (DE); Weidauer, Jens, 90763 Fürth (DE)

(57) **Zusammenfassung**

Die Erfindung betrifft einen integrierten Kontroller, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, einen modular aufgebauten Kontroller, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes, einen digitalen DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle Funktionseinheiten kompakt in einem Gerät umfasst, oder mit einem modular aufgebauten Kontroller, wobei der modular aufgebaute Kontroller ein- oder mehrmodulare separat austauschbare Module aufweist, ein Stromverteilungsnetz mit einem digitalen DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle Funktionseinheiten kompakt in einem Gerät umfasst, oder mit einem modular aufgebauten Kontroller, wobei der modular aufgebaute Kontroller ein- oder mehrmodulare separat austauschbare Module aufweist, ein Computerprogrammprodukt für einen optimierten Stromnetzbetrieb eines aus einem Wechselspannungs- oder Gleichspannungsnetz generierten Gleichspannungsnetzes oder Hybridnetzes, ein Verfahren für einen optimierten Stromnetzbetrieb eines aus einem Wechselspannungs- oder Gleichspan-nungsnetz generierten Gleichspannungsnetzes oder Hybridnetzes mittels eines integrierten Kontrollers, wobei der integrierte Kontroller alle Funktionseinheiten kompakt in einem Gerät umfasst, oder mittels eines modular aufgebauten Kontrollers, wobei der modular aufgebaute Kontroller ein- oder mehrmodulare separat austauschbare Module aufweist, sowie die Verwendung der erfindungsgemäßen Gegenstände in einer Automatisierungsanlage, in der Antriebstechnik oder in der Leistungselektronik.

## Beschreibung

Die Erfindung betrifft einen integrierten Kontroller, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, einen modular aufgebauten Kontroller, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes, einen digitalen DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle Funktionseinheiten kompakt in einem Gerät umfasst, oder mit einem modular aufgebauten Kontroller, wobei der modular aufgebaute Kontroller ein- oder mehrmodulare separat austauschbare Module aufweist, ein Stromverteilungsnetz mit einem digitalen DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle Funktionseinheiten kompakt in einem Gerät umfasst, oder mit einem modular aufgebauten Kontroller, wobei der modular aufgebaute Kontroller ein- oder mehrmodulare separat austauschbare Module aufweist, ein Computerprogrammprodukt für einen optimierten Stromnetzbetrieb eines aus einem Wechselspannungs- oder Gleichspannungsnetz generierten Gleichspannungsnetzes oder Hybridnetzes, ein Verfahren für einen optimierten Stromnetzbetrieb eines aus einem Wechselspannungs- oder Gleichspannungsnetz generierten Gleichspannungsnetzes oder Hybridnetzes mittels eines integrierten Kontrollers, wobei der integrierte Kontroller alle Funktionseinheiten kompakt in einem Gerät umfasst, oder mittels eines modular aufgebauten Kontrollers, wobei der modular aufgebaute Kontroller ein- oder mehrmodulare separat austauschbare Module aufweist, sowie die Verwendung der erfindungsgemäßen Gegenstände in einer Automatisierungsanlage, in der Antriebstechnik oder in der Leistungselektronik.

In gegenwärtigen, dem Standard entsprechenden AC-Netzen schalten übliche Leitungsschutzschalter mit elektromechanischer Auslösung innerhalb von einigen Millisekunden ab. Damit diese Abschaltung erfolgen kann, muss sich ein entsprechender Kurzschlussstrom aufbauen. Dieser sorgt häufig für Verschmorungen bzw. Brandspuren an der Stelle des Kurzschlusses. Die Fehlerstelle ist somit einfach zu lokalisieren.

Bei modernen DC-Netzen mit schellen, halbleiterbasierten Schaltern werden Fehlerfälle zeitnah, innerhalb von wenigen ps abgeschaltet. Eine Ausbildung eines Lichtbogens findet aufgrund der Kürze des Ereignisses nicht statt. Eine Lokalisation der Fehlerstelle ist entsprechend schwer möglich, da Verschmorungen bzw. Brandspuren keinen optischen Hinweis auf die Fehlerstelle bieten.

Demgemäß besteht die Aufgabe der vorliegenden Erfindung darin, einen Kontroller für einen optimierten Stromnetzbetrieb eines aus einem Wechselspannungs- oder Gleichspannungsnetz generierten Gleichspannungsnetzes oder Hybridnetzes mit einer zusätzlichen Funktion für eine schnelle Fehlerfallanalyse inklusive Ortung zu schaffen sowie ein dazugehöriges Verfahren und mögliche Anwendungen und Verwendungen der erfindungsgemäßen Gegenstände anzugeben.

Diese Aufgabe wird erfindungsgemäß gelöst durch: einen integrierten Kontroller, wobei der integrierte Kontroller alle Funktionseinheiten kompakt in einem Gerät umfasst, für einen optimierten Stromnetzbetrieb eines aus einem Wechselspannungs- oder Gleichspannungsnetzes generierten Gleichspannungsnetzes oder Hybridnetzes gemäß Anspruch 1, einen modular aufgebauten Kontroller, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes gemäß Anspruch 12, einen digitalen DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle Funktionseinheiten kompakt in einem Gerät umfasst, oder mit einem modular aufgebauten Kontroller, wobei der modular aufgebaute Kontroller ein- oder mehrmodulare separat austauschbare Module aufweist, gemäß Anspruch 23, ein Stromverteilungsnetz mit einem digitalen DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle Funktionseinheiten kompakt in einem Gerät umfasst, oder mit einem modular aufgebauten Kontroller, wobei der modular aufgebaute Kontroller ein- oder mehrmodulare separat austauschbare Module aufweist, gemäß Anspruch 34, ein Computerprogrammprodukt für einen optimierten Stromnetzbetrieb eines aus einem Wechselspannungs- oder Gleichspannungsnetz generierten Gleichspannungsnetzes oder Hybridnetzes gemäß Anspruch 45, ein Verfahren für einen optimierten Stromnetzbetrieb eines aus einem Wechselspannungs- oder Gleichspannungsnetz generierten Gleichspannungsnetzes oder Hybridnetzes mittels eines integrierten Kontrollers, wobei der integrierte Kontroller alle Funktionseinheiten kompakt in einem Gerät umfasst, oder mittels eines modular aufgebauten Kontrollers, wobei der modular aufgebaute Kontroller ein- oder mehrmodulare separat austauschbare Module aufweist gemäß Anspruch 50 sowie die Verwendung der erfindungsgemäßen Gegenstände in einer Automatisierungsanlage, in der Antriebstechnik oder in der Leistungselektronik gemäß der Ansprüche 59 bis 64. Vorteilhafte Aus- und Weiterbildungen, welche einzeln oder in Kombination miteinander eingesetzt werden können, sind jeweils der Gegenstand der abhängigen Ansprüche.

Erfindungsgemäß wird die Aufgabe durch einen integrierten Kontroller gelöst, wobei der integrierte Kontroller alle nachfolgenden Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes mit:
- einer Messeinrichtung zur Aufnahme von Messparametern des Stromnetzes;
- einer Zeitmesseinrichtung zur Aufnahme einer Zeitmessung und Zuordnung zu den aufgenommenen Messparametern;
- einer Auswerteeinheit zur Analyse und Bewertung der aufgenommenen Messparameter hinsichtlich eines zulässigen Netzbetriebs bzw. einer Überlastung;
- einem Speichermedium zur Dokumentation der Messparameter inklusive der zugeordneten Zeitmessungen sowie der Auswertungen;
- einer Steuereinheit zur Übermittlung möglicher Netzbetriebsänderungen,
wobei für einen Kurzschlussfall im Stromnetz in der Auswerteeinheit ein Algorithmus zur Ermittlung des überlasteten Abzweigs hinterlegt ist.

Die nachfolgenden Definitionen gelten für die komplette Anmeldung: Das Hybridnetz ist ein Stromnetz, in welchem sowohl ein oder mehrere Wechselstromnetzbereiche als auch ein oder mehrere Gleichstromnetzbereiche vorliegen. Der Abzweig kann ein Lastabzweig oder/und eine Einspeiseabzweig sein.

Der Kern der Erfindung besteht in der Kombination aus einer Echtzeitinformation, Messparametern wie der Spannungs- und Stromverlauf und einer Speicherung dieser Messdurchgänge inklusive einer anschließenden Auswertung in einem Speichermedium bzw. in einer Auswerteeinheit, auf welches im Fehlerfall zurückgegriffen werden kann, so dass mittels eines Algorithmuses die Ortung des fehlerhaften Abzweigs möglich ist.

Erfindungsgemäß ist vorzugsweise vorgesehen, dass zur späteren Analyse die Daten der Messeinrichtungen, insbesondere Spannung und Strom, aber auch die Temperatur in stromkreisführenden Stromkreiselementen oder die Anzahl der Schaltzyklen kurz vor und während der Abschaltung in einen Speicher geschrieben werden. Dies kann z.B. durch einen Ringspeicher gelöst werden. Spannung und Stromverläufe mit Vorzeichenangabe können in diesem Ringspeicher abgelegt werden.

Zusätzlich kann eine Zeitinformation, vorzugsweise mittels einer Echtzeituhr generiert werden und anschließend in einem Speicher hinterlegt werden. Diese Information kann zur übergeordneten Fehleridentifikation unter Berücksichtigung von Messdaten anderer Geräte verwendet werden. Die Echtzeituhr kann mittels Time-Server von zentraler Stelle gestellt werden mittels einer Kommunikationsschnittstelle oder ein Bestandteil des Kontrollers sein. Die Daten werden im Anschluss analysiert. Diese Analyse kann sowohl im Schaltgerät, in einem angebundenen Parametriergerät oder einer Cloud erfolgen. Die im Fehlerfall aufgenommenen Daten können entweder global im Zusammenhang ausgewertet werden oder nur lokal im Gerät Berücksichtigung finden. Der Verlauf des Stromanstiegs bzw. der gleichzeitige Spannungsabfall können zur Bestimmung des Leitungswiderstands und der Induktivität verwendet werden, welche in der Strecke zwischen Schaltgerät und Fehlerstelle auftreten. Über diese Werte und die typischen Leitungsbeläge kann eine Abschätzung der Entfernung vorgenommen werden. In dieser Berechnung findet zusätzlich die Spannung im Schalter Berücksichtigung.

Der Vorteil dieser Erfindung besteht darin, dass eine Fehlersuche in einem DC-Abgang eines verteilten DC-Netzes erheblich vereinfacht wird. Falls in dieser Anwendung keine Informationen über die Entfernung der Fehlerstelle vorliegen, ist eine Lokalisation mittels zusätzlichen Messequipments erforderlich, womit ein deutlich höherer Aufwand verbunden ist. Insbesondere bei weitläufigen Netzausprägungen hilft eine ungefähre Aussage über die Entfernung entsprechende Aufwände zur Lokalisation zu vermindern. Durch den übergeordneten Vergleich können zusätzlich Fehlparametrierungen in den DC-Schaltern identifiziert werden. Die Information über die Entfernung der Fehlerstelle kann per APP oder am Gerät visualisiert werden. Eine App (Abkürzung für "Application Software") ist eine Anwendungssoftware oder ein Computerprogogramm, welches unterschiedliche Funktionen erfüllen kann. Sie hat dabei keine systemtechnische Funktionalität, sodass das System auch ohne dieses Programm ordnungsgemäß arbeiten kann. Ein entsprechender Dienst könnte intrinsisch in der Firmware des Schalters vorhanden sein. Es ist aber auch eine Bereitstellung als Cloud-Dienst denkbar. Das Gerät übernimmt dann lediglich die Aufzeichnung der Daten. Der Kunde könnte so im Fehlerfall einen Dienst in Anspruch nehmen und für die einmalige Auswertung bezahlen.

DC-Schalter werden bedingt durch ihre Funktionsweise über eine Strom- und eine Spannungsmessung verfügen. Diese Messsignale sollen neben der Ableitung von Auslösekriterien für den DC-Schalter auch zur Analyse der Netzqualität und zur Erfassung der Energie verwendet werden. Dazu wird ein Kontroller integriert, welcher folgende Aufgaben vorzugsweise in Form einer Software realisiert:
- Echtzeituhr, die von einem externen Zeitgeber synchronisiert werden kann;
- Bereitstellen von Augenblickswerten des Stromes, der Spannung und der Leistung;
- Bereitstellen von Mittelwerten des Stromes, der Spannung und der Leistung;
- Bereitstellen der aufgenommenen und der abgegebenen Energie;
- Bereitstellen des Oberschwingungsgehalts von Strom und Spannung aufgeteilt auf einzelne harmonische Werte sowie als integralen Wert (THD, Klirrfaktor);
- Darstellen der Messwerte in einem Display;
- Übertragung der Werte zu einem überlagerten Leitsystem über eine Kommunikationsschnittstelle.

Eine Fortführung des erfindungsgemäßen Konzepts für den integrierten Kontroller kann darin bestehen, dass die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs aufnimmt.

Eine spezielle Ausgestaltung dieses erfindungsgemäßen Konzepts für den integrierten Kontroller kann darin bestehen, dass die Zeitmesseinrichtung eine Echtzeitmessung ist, welche einen Zeitzwischenraum bestimmt, oder Uhrzeitmessungen, aus welchen der Zeitzwischenraum zu ermitteln ist.

Eine Erweiterung einer speziellen Ausgestaltung des erfindungsgemäßen Konzepts für den integrierten Kontroller kann vorsehen, dass der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

Ein vorteilhafter zusätzlicher Aspekt des erfindungsgemäßen Konzepts für den integrierten Kontroller kann darin bestehen, dass der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Lastabzweigen ist, wobei eine abweichende Vergleichsmessung zum archivierten Messwert, welcher einem Erfahrungswert entspricht und an welchem die Abweichungen festgelegt werden, an einer bestimmten Stelle im Stromnetz den Kurzschluss auslösenden Abzweig kennzeichnet.

Es entspricht einer speziellen Ausführungsform des erfindungsgemäßen Konzepts für den integrierten Kontroller, dass der Algorithmus zur Ermittlung des überlasteten Abzweigs im Stromnetz in Form einer Fuzzy-Logik ausgebildet ist.

Eine Fortführung des erfindungsgemäßen Konzepts für den integrierten Kontroller kann darin bestehen, dass der Algorithmus zur Ermittlung des überlasteten Abzweigs im Stromnetz als Priorisierung nach der Wahrscheinlichkeit innerhalb einer Fuzzy-Logik ausgebildet ist. Die Wahrscheinlichkeit ergibt sich dabei aus den bereits hinterlegten Messdurchgängen, welche als Erfahrungswerte dienen. Der Algorithmus "lernt" das Netz kennen und gibt mittels der Erfahrungswerte eine Priorisierung vor.

Eine spezielle Ausgestaltung dieses erfindungsgemäßen Konzepts für den integrierten Kontroller kann darin bestehen, dass für einen optimierten Stromnetzbetrieb eine Priorisierung der unterschiedlichen zur Anwendung zu bringenden Algorithmen in der Auswerteeinheit des integrierten Kontrollers hinterlegt ist. Dieser Priorisierung kann eine Simulationsberechnung der einzelnen Algorithmen zu Grunde liegen, aus welcher der sinnvollste Algorithmus bzw. die sinnvollste Parametrierung ausgewählt werden.

Eine Erweiterung einer speziellen Ausgestaltung des erfindungsgemäßen Konzepts für den integrierten Kontroller kann vorsehen, dass die Priorisierung der Algorithmen auf einer Auswertung von Erfahrungswerten basierend ausgebildet ist und in Form einer Teach-In-Funktion in die Auswerteeinheit zu integrieren ist.

Ein vorteilhafter zusätzlicher Aspekt des erfindungsgemäßen Konzepts für den integrierten Kontroller kann darin bestehen, dass in der Steuereinheit eine Auslösekennlinie für eine Überlastung hinterlegt ist, welche einen Abschaltvorgang im Abzweig auslöst.

Eine weitere wesentliche Ausgestaltung des erfindungsgemäßen Konzept für den integrierten Kontroller besteht darin, dass der integrierte Kontroller eine Kommunikationsschnittstelle aufweist, welche eine Anbindung an eine Cloud oder ein anderes externes oder internes Medium bzw. eine Auswerteeinheit ermöglicht.

Die Aufgabe wird erfindungsgemäß auch durch einen modular aufgebauten Kontroller gelöst, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes mit:
- einem Modul für eine Messeinrichtung zur Aufnahme von Messparametern des Stromnetzes;
- einem Modul für eine Zeitmesseinrichtung zur Aufnahme einer Zeitmessung und Zuordnung zu den aufgenommenen Messparametern;
- einem Modul für eine Auswerteeinheit zur Analyse und Bewertung der aufgenommenen Messparameter hinsichtlich eines zulässigen Netzbetriebs bzw. einer Überlastung;
- einem Modul für ein Speichermedium zur Dokumentation der Messparameter inklusive der zugeordneten Zeitmessungen sowie der Auswertungen;
- einem Modul für eine Steuereinheit zur Übermittlung möglicher Netzbetriebsänderungen,
wobei für einen Kurzschlussfall im Stromnetz in der Auswerteeinheit ein Algorithmus zur Ermittlung des überlasteten Abzweigs hinterlegt ist.

Eine Fortführung des erfindungsgemäßen Konzepts für den modular aufgebauten Kontroller kann darin bestehen, dass die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs aufnimmt.

Eine spezielle Ausgestaltung dieses erfindungsgemäßen Konzepts für den modular aufgebauten Kontroller kann darin bestehen, dass die Zeitmesseinrichtung eine Echtzeitmessung ist, welche einen Zeitzwischenraum bestimmt, oder Uhrzeitmessungen, aus welchen der Zeitzwischenraum zu ermitteln ist.

Eine Erweiterung einer speziellen Ausgestaltung des erfindungsgemäßen Konzepts für den modular aufgebauten Kontroller kann vorsehen, dass der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

Ein vorteilhafter zusätzlicher Aspekt des erfindungsgemäßen Konzepts für den modular aufgebauten Kontroller kann darin bestehen, dass der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Abzweigen ist, wobei eine abweichende Vergleichsmessung zum archivierten Messwert an einer bestimmten Stelle im Stromnetz den Kurzschluss auslösenden Abzweig kennzeichnet.

Es entspricht einer speziellen Ausführungsform des erfindungsgemäßen Konzepts für den modular aufgebauten Kontroller, dass der Algorithmus zur Ermittlung des überlasteten Abzweigs im Stromnetz in Form einer Fuzzy-Logik ausgebildet ist.

Eine Fortführung des erfindungsgemäßen Konzepts für den modular aufgebauten Kontroller kann darin bestehen, dass der Algorithmus zur Ermittlung des überlasteten Abzweigs im Stromnetz als Priorisierung nach der Wahrscheinlichkeit innerhalb einer Fuzzy-Logik ausgebildet ist.

Eine spezielle Ausgestaltung dieses erfindungsgemäßen Konzepts für den modular aufgebauten Kontroller kann darin bestehen, dass für einen optimierten Stromnetzbetrieb eine Priorisierung der unterschiedlichen zur Anwendung zu bringenden Algorithmen in der Auswerteeinheit des modular aufgebauten Kontrollers hinterlegt ist.

Eine Erweiterung einer speziellen Ausgestaltung des erfindungsgemäßen Konzepts für den modular aufgebauten Kontroller kann vorsehen, dass eine Priorisierung der Algorithmen auf einer Auswertung von Erfahrungswerten basierend ausgebildet ist und in Form einer Teach-In-Funktion in die Auswerteeinheit zu integrieren ist.

Ein vorteilhafter zusätzlicher Aspekt des erfindungsgemäßen Konzepts kann darin bestehen, dass in der Steuereinheit eine Auslösekennlinie für eine Überlastung hinterlegt ist, welche einen Abschaltvorgang im Abzweig auslöst.

Eine weitere wesentliche Ausgestaltung des erfindungsgemäßen Konzepts für den modular aufgebauten Kontroller besteht darin, dass der modular aufgebaute Kontroller eine Kommunikationsschnittstelle aufweist, welche eine Anbindung an eine Cloud oder ein anderes externes oder internes Medium bzw. eine Auswerteeinheit ermöglicht.

Die Aufgabe wird erfindungsgemäß zudem durch einen digitalen DC-Schalter gelöst für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle nachfolgenden Funktionseinheiten kompakt in einem Gerät umfasst, oder mit einem modular aufgebauten Kontroller, wobei der modular aufgebaute Kontroller ein- oder mehrmodulare separat austauschbare Module aufweist, umfassend:
- eine Messeinrichtung zur Aufnahme von Messparametern des Stromnetzes modular oder integriert ausgeführt;
- eine Zeitmesseinrichtung zur Aufnahme einer Zeitmessung und Zuordnung zu den aufgenommenen Messparametern modular oder integriert ausgeführt;
- eine Auswerteeinheit zur Analyse und Bewertung der aufgenommenen Messparameter hinsichtlich eines zulässigen Netzbetriebs bzw. einer Überlastung modular oder integriert ausgeführt;
- ein Speichermedium zur Dokumentation der Messparameter inklusive der zugeordneten Zeitmessungen sowie der Auswertungen modular oder integriert ausgeführt;
- eine Steuereinheit zur Übermittlung möglicher Netzbetriebsänderungen modular oder integriert ausgeführt,
wobei für einen Kurzschlussfall im Stromnetz in der Auswerteeinheit ein Algorithmus zur Ermittlung des überlasteten Abzweigs hinterlegt ist. Der erfindungsgemäße digitale DC-Schalter kann als separater, diskreter Schalter ausgebildet sein, welcher als solcher ein bestellbares Produkt darstellt. Es kann sich beim digitalen DC-Schalter aber auch um einen diskreten Teilbereich des erfindungsgemäßen Stromverteilungsnetzes handeln. Der digitale DC-Schalter kann zudem Vorladeschaltungen aufweisen, welche Vorladewiderstände und Kondensatoren beinhalten.

Eine Fortführung des erfindungsgemäßen Konzepts für den digitalen DC-Schalter kann darin bestehen, dass die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs aufnimmt.

Eine spezielle Ausgestaltung dieses erfindungsgemäßen Konzepts für den digitalen DC-Schalter kann darin bestehen, dass die Zeitmesseinrichtung eine Echtzeitmessung ist, welche einen Zeitzwischenraum bestimmt, oder Uhrzeitmessungen, aus welchen der Zeitzwischenraum zu ermitteln ist.

Eine Erweiterung einer speziellen Ausgestaltung des erfindungsgemäßen Konzepts für den digitalen DC-Schalter kann vorsehen, dass der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

Ein vorteilhafter zusätzlicher Aspekt des erfindungsgemäßen Konzepts für den digitalen DC-Schalter kann darin bestehen, dass der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Abzweigen ist, wobei eine abweichende Vergleichsmessung zum archivierten Messwert an einer bestimmten Stelle im Stromnetz den Kurzschluss auslösenden Abzweig kennzeichnet.

Es entspricht einer speziellen Ausführungsform des erfindungsgemäßen Konzepts für den digitalen DC-Schalter, dass der Algorithmus zur Ermittlung des überlasteten Abzweigs im Stromnetz in Form einer Fuzzy-Logik ausgebildet ist.

Eine Fortführung des erfindungsgemäßen Konzepts für den digitalen DC-Schalter kann darin bestehen, dass der Algorithmus zur Ermittlung des überlasteten Abzweigs im Stromnetz als Priorisierung nach der Wahrscheinlichkeit innerhalb einer Fuzzy-Logik ausgebildet ist.

Eine spezielle Ausgestaltung dieses erfindungsgemäßen Konzepts für den digitalen DC-Schalter kann darin bestehen, dass für einen optimierten Stromnetzbetrieb eine Priorisierung der unterschiedlichen zur Anwendung zu bringenden Algorithmen in der Auswerteeinheit des integrierten oder modular aufgebauten Kontrollers hinterlegt ist.

Eine Erweiterung einer speziellen Ausgestaltung des erfindungsgemäßen Konzepts für den digitalen DC-Schalter kann vorsehen, dass die Priorisierung der Algorithmen auf einer Auswertung von Erfahrungswerten basierend ausgebildet ist und in Form einer Teach-In-Funktion in die Auswerteeinheit zu integrieren ist.

Ein vorteilhafter zusätzlicher Aspekt des erfindungsgemäßen Konzepts kann darin bestehen, dass in der Steuereinheit eine Auslösekennlinie für eine Überlastung hinterlegt ist, welche einen Abschaltvorgang im Abzweig auslöst.

Eine weitere wesentliche Ausgestaltung des erfindungsgemäßen Konzepts für den digitalen DC-Schalter besteht darin, dass der integrierte oder modular aufgebaute Kontroller eine Kommunikationsschnittstelle aufweist, welche eine Anbindung an eine Cloud oder ein anderes externes oder internes Medium bzw. eine Auswerteeinheit ermöglicht.

Die Aufgabe wird erfindungsgemäß außerdem durch ein Stromverteilungsnetz mit einem digitalen DC-Schalter gelöst für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle nachfolgenden Funktionseinheiten kompakt in einem Gerät umfasst, oder mit einem modular aufgebauten Kontroller, wobei der modular aufgebaute Kontroller ein- oder mehrmodulare separat austauschbare Module aufweist, umfassend:
- eine Messeinrichtung zur Aufnahme von Messparametern des Stromnetzes modular oder integriert ausgeführt;
- eine Zeitmesseinrichtung zur Aufnahme einer Zeitmessung und Zuordnung zu den aufgenommenen Messparametern modular oder integriert ausgeführt;
- eine Auswerteeinheit zur Analyse und Bewertung der aufgenommenen Messparameter hinsichtlich eines zulässigen Netzbetriebs bzw. einer Überlastung modular oder integriert ausgeführt;
- ein Speichermedium zur Dokumentation der Messparameter inklusive der zugeordneten Zeitmessungen sowie der Auswertungen modular oder integriert ausgeführt;
- eine Steuereinheit zur Übermittlung möglicher Netzbetriebsänderungen modular oder integriert ausgeführt,
wobei für einen Kurzschlussfall im Stromnetz in der Auswerteeinheit ein Algorithmus zur Ermittlung des überlasteten Abzweigs hinterlegt ist.

Eine Fortführung des erfindungsgemäßen Konzepts für das Stromverteilungsnetz kann darin bestehen, dass die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs aufnimmt.

Eine spezielle Ausgestaltung dieses erfindungsgemäßen Konzepts kann darin bestehen, dass die Zeitmesseinrichtung eine Echtzeitmessung ist, welche einen Zeitzwischenraum bestimmt, oder Uhrzeitmessungen, aus welchen der Zeitzwischenraum zu ermitteln ist.

Eine Erweiterung einer speziellen Ausgestaltung des erfindungsgemäßen Konzepts für das Stromverteilungsnetz kann vorsehen, dass der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

Ein vorteilhafter zusätzlicher Aspekt des erfindungsgemäßen Konzepts für das Stromverteilungsnetz kann darin bestehen, dass der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Lastabzweigen ist, wobei eine abweichende Vergleichsmessung zum archivierten Messwert an einer bestimmten Stelle im Stromnetz den Kurzschluss auslösenden Abzweig kennzeichnet.

Es entspricht einer speziellen Ausführungsform des erfindungsgemäßen Konzepts für das Stromverteilungsnetz, dass der Algorithmus zur Ermittlung des überlasteten Abzweigs im Stromnetz in Form einer Fuzzy-Logik ausgebildet ist.

Eine Fortführung des erfindungsgemäßen Konzepts für das Stromverteilungsnetz kann darin bestehen, dass der Algorithmus zur Ermittlung des überlasteten Abzweigs im Stromnetz als Priorisierung nach der Wahrscheinlichkeit innerhalb einer Fuzzy-Logik ausgebildet ist.

Eine spezielle Ausgestaltung dieses erfindungsgemäßen Konzepts für das Stromverteilungsnetz kann darin bestehen, dass für einen optimierten Stromnetzbetrieb eine Priorisierung der unterschiedlichen zur Anwendung zu bringenden Algorithmen in der Auswerteeinheit des integrierten oder modular aufgebauten Kontrollers hinterlegt ist.

Eine Erweiterung einer speziellen Ausgestaltung des erfindungsgemäßen Konzepts für das Stromverteilungsnetz kann vorsehen, dass die Priorisierung der Algorithmen auf einer Auswertung von Erfahrungswerten basierend ausgebildet ist und in Form einer Teach-In-Funktion in die Auswerteeinheit zu integrieren ist.

Ein vorteilhafter zusätzlicher Aspekt des erfindungsgemäßen Konzepts für das Stromverteilungsnetz kann darin bestehen, dass in der Steuereinheit eine Auslösekennlinie für eine Überlastung hinterlegt ist, welche einen Abschaltvorgang im Abzweig auslöst.

Eine weitere wesentliche Ausgestaltung des erfindungsgemäßen Konzepts für das Stromverteilungsnetz besteht darin,, dass der integrierte oder modular aufgebaute Kontroller eine Kommunikationsschnittstelle aufweist, welche eine Anbindung an eine Cloud oder ein anderes externes oder internes Medium bzw. eine Auswerteeinheit ermöglicht.

Die Aufgabe wird erfindungsgemäß auch durch ein Computerprogrammprodukt für einen optimierten Stromnetzbetrieb eines aus einem Wechselspannungs- oder Gleichspannungsnetz generierten Gleichspannungsnetzes oder Hybridnetzes gelöst, welches auf einem Medium mit einer funktionalen Ausrichtung als Computer gespeichert ist und mediumlesbare Programmittel aufweist, welche das Medium dazu veranlassen, ermittelte Messparameter des Stromnetzes auszuwerten und hinsichtlich eines zulässigen Netzbetriebs bzw. einer Überlastung zu bewerten, wobei für einen Kurzschlussfall im Stromnetz ein Algorithmus zur Ermittlung des überlasteten Abzweigs durchgeführt wird.

Es entspricht einer speziellen Ausführungsform des erfindungsgemäßen Konzepts für das Computerprogrammprodukt, dass das Computerprogrammprodukt mediumlesbare Programmittel aufweist, welche das Medium dazu veranlassen, zur Ermittlung des überlasteten Abzweigs im Stromnetz einen Algorithmus in Form einer Fuzzy-Logik zu durchlaufen.

Eine Fortführung des erfindungsgemäßen Konzepts für das Computerprogrammprodukt kann darin bestehen, dass das Computerprogrammprodukt mediumlesbare Programmittel aufweist, welche das Medium dazu veranlassen, einen Algorithmus zur Ermittlung des überlasteten Abzweigs im Stromnetz auf Basis einer vergleichenden Einzelanalyse aller zugeschalteter Abzweige mit bereits im Speichermedium archivierten Messpunkten zu den jeweiligen Abzweigen zu durchlaufen, wobei eine abweichende Vergleichsmessung zum archivierten Messwert an einer bestimmten Stelle im Stromnetz den Kurzschluss auslösenden Abzweig kennzeichnet.

Eine spezielle Ausgestaltung dieses erfindungsgemäßen Konzepts für das Computerprogrammprodukt kann darin bestehen, dass das Computerprogrammprodukt mediumlesbare Programmittel aufweist, welche das Medium dazu veranlassen, einen Algorithmus zur Ermittlung des überlasteten Abzweigs im Stromnetz in Form einer Priorisierung nach der Wahrscheinlichkeit innerhalb einer Fuzzy-Logik zu durchlaufen.

Eine Erweiterung einer speziellen Ausgestaltung des erfindungsgemäßen Konzepts für das Computerprogrammprodukt kann vorsehen, dass das Computerprogrammprodukt mediumlesbare Programmittel aufweist, welche das Medium dazu veranlassen, für einen optimierten Stromnetzbetrieb eine Priorisierung der unterschiedlichen zur Anwendung zu bringenden Algorithmen zu ermitteln.

Die Aufgabe wird erfindungsgemäß des Weiteren durch ein Verfahren gelöst für einen optimierten Stromnetzbetrieb eines aus einem Wechselspannungs- oder Gleichspannungsnetz generierten Gleichspannungsnetzes oder Hybridnetzes mittels eines integrierten Kontrollers, wobei der integrierte Kontroller alle nachfolgenden Funktionseinheiten kompakt in einem Gerät umfasst, oder mittels eines modular aufgebauten Kontrollers, wobei der modular aufgebaute Kontroller ein- oder mehrmodulare separat austauschbare Module aufweist, mit den Schritten:
- Messen von Messparametern des Stromnetzes mittels einer Messeinrichtung des modular aufgebauten oder integrierten Kontrollers;
- Messen der Zeit und zuordnen der Zeitmesswerte zu den aufgenommenen Messparametern mittels einer Zeitmesseinrichtung des modular aufgebauten oder integrierten Kontrollers;

- Auswerten und bewerten der aufgenommenen Messparameter hinsichtlich eines zulässigen Netzbetriebs bzw. einer Überlastung mittels einer Auswerteeinheit des modular aufgebauten oder integrierten Kontrollers;
- Speichern der Messparameter inklusive der zugeordneten Zeitmessungen sowie der ausgewerteten Messdurchgänge zur Dokumentation mittels eines Speichermediums des modular aufgebauten oder integrierten Kontrollers;
- Aussteuern möglicher Netzbetriebsänderungen mittels einer Steuereinheit des modular aufgebauten oder integrierten Kontrollers,
wobei für einen Kurzschlussfall im Stromnetz ein Algorithmus zur Ermittlung des überlasteten Abzweigs durchgeführt wird.

Eine Fortführung des erfindungsgemäßen Konzepts für das Verfahren kann darin bestehen, dass als Messparameter für das Stromnetz Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs ermittelt werden.

Eine spezielle Ausgestaltung des erfindungsgemäßen Konzepts für das Verfahren kann darin bestehen, dass die Zeitmessung als Echtzeitmessung, welche einen Zeitzwischenraum bestimmt, oder in Form von Uhrzeitmessungen durchgeführt wird, aus welchen der Zeitzwischenraum ermittelt wird.

Eine Erweiterung einer speziellen Ausgestaltung des erfindungsgemäßen Konzepts für das Verfahren kann vorsehen, dass der Algorithmus zur Ermittlung des überlasteten Abzweigs im Stromnetz im ersten Schritt als Messung zumindest eines Messparameters an Knotenpunkten im Stromnetz durchgeführt wird, an welchen zumindest ein Abzweig zugeschaltet ist, welche mit dem Messwert eines zuvor hinterlegten Messdurchgangs verglichen wird, und dass im zweiten Schritt in den zugehörigen Abzweigen dieses Knotenpunkts mit einer abweichenden Messung zum vorherigen Messdurchgang weiterführende Messungen durchgeführt werden.

Ein vorteilhafter zusätzlicher Aspekt des erfindungsgemäßen Konzepts für das Verfahren kann darin bestehen, dass der Algorithmus zur Ermittlung des überlasteten Abzweigs im Stromnetz als vergleichende Einzelanalyse aller zugeschalteter Abzweige mit bereits im Speichermedium archivierten Messpunkten zu den jeweiligen Abzweigen durchgeführt wird, wobei eine abweichende Vergleichsmessung zum archivierten Messwert an einer bestimmten Stelle im Stromnetz den Kurzschluss auslösenden Abzweig kennzeichnet.

Es entspricht einer speziellen Ausführungsform des erfindungsgemäßen Konzepts für das Verfahren, dass der Algorithmus zur Ermittlung des überlasteten Abzweigs im Stromnetz in Form einer Fuzzy-Logik durchgeführt wird.

Eine Fortführung des erfindungsgemäßen Konzepts für das Verfahren kann darin bestehen, dass der Algorithmus zur Ermittlung des überlasteten Abzweigs im Stromnetz als Priorisierung nach der Wahrscheinlichkeit innerhalb einer Fuzzy-Logik durchgeführt wird.

Eine spezielle Ausgestaltung des erfindungsgemäßen Konzepts für das Verfahren kann darin bestehen, dass die Priorisierung der Algorithmen auf einer Auswertung von Erfahrungswerten basierend durchgeführt wird und in Form einer Teach-In-Funktion auf eine Auswerteeinheit innerhalb des Kontrollers eingespielt wird.

Eine Erweiterung einer speziellen Ausgestaltung des erfindungsgemäßen Konzepts für das Verfahren kann vorsehen, dass durch eine Auslösekennlinie in einer Steuereinheit, welche eine Überlastung kennzeichnet, ein Abschaltvorgang im Abzweig ausgelöst wird.

Die Aufgabe wird erfindungsgemäß insbesondere gelöst durch eine Verwendung eines integrierten Kontrollers gemäß der Ansprüche 1 bis 11, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, oder eines modular aufgebauten Kontrollers gemäß der Ansprüche 12 bis 22, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes in einem digitalen DC-Schalter gemäß der Ansprüche 23 bis 33 und mittels des digitalen DC-Schalters in einem Stromverteilungsnetz gemäß der Ansprüche 34 bis 44 in einer Automatisierungsanlage.

Die Aufgabe wird erfindungsgemäß vorzugsweise gelöst durch eine Verwendung eines integrierten Kontrollers gemäß der Ansprüche 1 bis 11, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, oder eines modular aufgebauten Kontrollers gemäß der Ansprüche 12 bis 22, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes in einem digitalen DC-Schalter gemäß der Ansprüche 23 bis 33 und mittels des digitalen DC-Schalters in einem Stromverteilungsnetz gemäß der Ansprüche 34 bis 44 in der Antriebstechnik.

Die Aufgabe wird erfindungsgemäß auch gelöst durch eine Verwendung eines integrierten Kontrollers gemäß der Ansprüche 1 bis 11, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, oder eines modular aufgebauten Kontrollers gemäß der Ansprüche 12 bis 22, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes in einem digitalen DC-Schalter gemäß der Ansprüche 22 bis 33 und mittels des digitalen DC-Schalters in einem Stromverteilungsnetz gemäß der Ansprüche 34 bis 44 in der Leistungselektronik.

Die Aufgabe wird erfindungsgemäß außerdem durch eine Verwendung eines Computerprogrammprodukts für einen optimierten Stromnetzbetrieb eines aus einem Wechselspannungs- oder Gleichspannungsnetz generierten Gleichspannungsnetzes oder Hybridnetzes gemäß der Ansprüchen 45 bis 49 in einer Automatisierungsanlage gelöst.

Die Aufgabe wird erfindungsgemäß zudem durch eine Verwendung eines Computerprogrammprodukts für einen optimierten Stromnetzbetrieb eines aus einem Wechselspannungs- oder Gleichspannungsnetz generierten Gleichspannungsnetzes oder Hybridnetzes gemäß der Ansprüchen 45 bis 49 in der Antriebstechnik gelöst.

Die Aufgabe wird erfindungsgemäß schließlich auch durch eine Verwendung eines Computerprogrammprodukts für einen optimierten Stromnetzbetrieb eines aus einem Wechselspannungs- oder Gleichspannungsnetz generierten Gleichspannungsnetzes oder Hybridnetzes gemäß der Ansprüchen 45 bis 49 in der Leistungselektronik gelöst.

Der erfindungsgemäße integrierte oder modular aufgebaute Kontroller für einen optimierten Stromnetzbetrieb eines aus einem Wechselspannungs- oder Gleichspannungsnetz generierten Gleichspannungsnetzes oder Hybridnetzes kann in einem digitalen DC-Schalter angeordnet sein. Dieser digitale DC-Schalter kann als kompaktes Gerät ausgebildet sein oder offen im Stromverteilungsnetz als Teilbereich dieses Netzes integriert sein. Der digitale DC-Schalter ist mit einem grafischen Anzeigemedium beispielsweise einem Display verbunden, auf welchem das Stromverteilungsnetz dargestellt werden kann. Vorzugsweise verfügt der Kontroller über eine Kodierung, welche als Schnittstelle zu einer Grafikkarte ausgebildet ist, so dass die Fehlerstelle im Stromverteilungsnetz entweder farbig und/oder durch gepulstes Anzeigen sichtbar gemacht werden kann. Der digitale DC-Schalter weist eine Kommunikationsverbindung zu einem Leitsystem auf. Dieses Leitsystem kann insbesondere als Cloud oder als ein anderes externes Medium mit einer anderen Art der Nachrichtenübermittlung oder als internes Medium ausgebildet sein.

Weitere Ausführungen und Vorteile der Erfindung werden nachfolgend anhand eines Ausführungsbeispiels sowie anhand der Zeichnung erläutert.

Dabei zeigt:

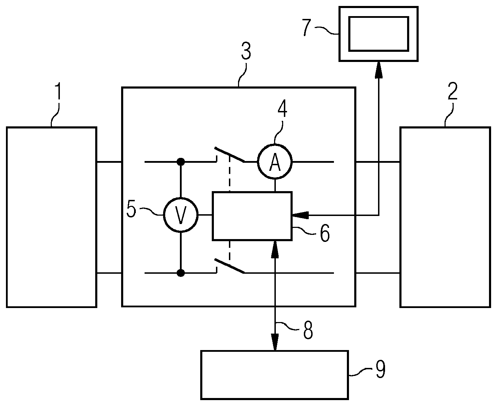

- Fig. 1: in einer schematischen Darstellung einen Überblick vom Stromerzeuger bis zum Netzteilnehmer innerhalb eines DC-Netzes mit einem erfindungsgemäßen digitalen DC-Schalter.

In Fig. 1 zeigt einen Überblick vom Stromerzeuger 1 bis zum Netzteilnehmer 2, welcher als Verbraucher oder Erzeuger ausgebildet sein kann, innerhalb eines DC-Netzes mit einem erfindungsgemäßen digitalen DC-Schalter 3. Der erfindungsgemäße DC-Schalter 3 ist innerhalb des DC-Netzes zwischen dem Stromerzeuger 1 und dem Verbraucher 3 positioniert. Im DC-Schalter 3 ist vorzugsweise eine Strommesseinrichtung 4 und eine Spannungsmesseinrichtung 5 angeordnet. Darüber hinaus weist der digitale DC-Schalter 3 einen übergeordneten Kontroller 6 auf, welcher mit den Strom- und Spannungsmesseinrichtungen 4, 5 verbunden ist. Der Kontroller 6 kann mit einem Display 7 verbunden sein, welches entweder extern außerhalb des digitalen DC-Schalters 3 oder im digitalen DC-Schalter 3 integriert angeordnet ist. Der Kontroller 6 kann außerdem über eine Kommunikationsverbindung 8 mit einem Leitsystem 9 verbunden sein. Der digitale DC-Schalter 3 kann als kompaktes Gerät ausgebildet sein oder offen im Stromverteilungsnetz als Teilbereich dieses Netzes integriert sein.

Der erfindungsgemäße integrierte oder modular aufgebaute Kontroller für einen optimierten Stromnetzbetrieb eines aus einem Wechselspannungs- oder Gleichspannungsnetz generierten Gleichspannungsnetzes oder Hybridnetzes, der dazugehörige digitale DC-Schalter, das Stromverteilungsnetz mit diesem digitalen DC-Schalter sowie das Verfahren für einen optimierten Stromnetzbetrieb eines aus einem Wechselspannungs- oder Gleichspannungsnetz generierten Gleichspannungsnetzes oder Hybridnetzes mittels eines Kontrollers zeichnen sich dadurch aus, dass mittels eines Computerprogrammprodukts das zielgerichtete Durchlaufen von Algorithmen mit unterschiedlichen Vorgehensweisen eine Ortung einer Fehlerstelle im DC-Netz ermöglicht.

### Bezugszeichenliste

- 1: Stromerzeuger
- 2: Netzteilnehmer
- 3: Digitaler DC-Schalter
- 4: Strommesseinrichtung
- 5: Spannungsmesseinrichtung
- 6: Übergeordneter Kontroller
- 7: Display
- 8: Kommunikationsverbindung
- 9: Leitsystem

## Patentansprüche

1. Integrierter Kontroller, wobei der integrierte Kontroller alle nachfolgenden Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes mit:
- einer Messeinrichtung zur Aufnahme von Messparametern des Stromnetzes;
- einer Zeitmesseinrichtung zur Aufnahme einer Zeitmessung und Zuordnung zu den aufgenommenen Messparametern;
- einer Auswerteeinheit zur Analyse und Bewertung der aufgenommenen Messparameter hinsichtlich eines zulässigen Netzbetriebs bzw. einer Überlastung;
- einem Speichermedium zur Dokumentation der Messparameter inklusive der zugeordneten Zeitmessungen sowie der Auswertungen;
- einer Steuereinheit zur Übermittlung möglicher Netzbetriebsänderungen,
wobei für einen Kurzschlussfall im Stromnetz in der Auswerteeinheit ein Algorithmus zur Ermittlung des überlasteten Abzweigs hinterlegt ist.

2. Integrierter Kontroller nach Anspruch 1, **dadurch gekennzeichnet, dass** die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Lastabzweigs aufnimmt.

3. Integrierter Kontroller nach Anspruch 1 oder 2, **dadurch gekennzeichnet, dass** die Zeitmesseinrichtung eine Echtzeitmessung ist, welche einen Zeitzwischenraum bestimmt, oder Uhrzeitmessungen, aus welchen der Zeitzwischenraum zu ermitteln ist.

4. Integrierter Kontroller nach einem der Ansprüche 1 bis 3, **dadurch gekennzeichnet, dass** der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

5. Integrierter Kontroller nach einem der Ansprüche 1 bis 3, **dadurch gekennzeichnet, dass** der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Abzweigen ist, wobei eine abweichende Vergleichsmessung zum archivierten Messwert an einer bestimmten Stelle im Stromnetz den Kurzschluss auslösenden Abzweig kennzeichnet.

6. Integrierter Kontroller nach einem der Ansprüche 1 bis 3, **dadurch gekennzeichnet, dass** der Algorithmus zur Ermittlung des überlasteten Abzweigs im Stromnetz in Form einer Fuzzy-Logik ausgebildet ist.

7. Integrierter Kontroller nach einem der Ansprüche 1 bis 3, **dadurch gekennzeichnet, dass** der Algorithmus zur Ermittlung des überlasteten Abzweigs im Stromnetz als Priorisierung nach der Wahrscheinlichkeit innerhalb einer Fuzzy-Logik ausgebildet ist.

8. Integrierter Kontroller nach einem der Ansprüche 4 bis 7, **dadurch gekennzeichnet, dass** für einen optimierten Stromnetzbetrieb eine Priorisierung der unterschiedlichen zur Anwendung zu bringenden Algorithmen in der Auswerteeinheit des integrierten Kontrollers hinterlegt ist.

9. Integrierter Kontroller nach Anspruch 8, **dadurch gekennzeichnet, dass** Priorisierung der Algorithmen auf einer Auswertung von Erfahrungswerten basierend ausgebildet ist und in Form einer Teach-In-Funktion in die Auswerteeinheit zu integrieren ist.

10. Integrierter Kontroller nach einem der Ansprüche 1 bis 9, **dadurch gekennzeichnet, dass** in der Steuereinheit eine Auslösekennlinie für eine Überlastung hinterlegt ist, welche einen Abschaltvorgang im Abzweig auslöst.

11. Integrierter Kontroller nach einem der Ansprüche 1 bis 10, **dadurch gekennzeichnet, dass** der integrierte Kontroller eine Kommunikationsschnittstelle aufweist, welche eine Anbindung an eine Cloud oder ein anderes externes oder internes Medium bzw. eine Auswerteeinheit ermöglicht.

12. Modular aufgebauter Kontroller, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes mit:
- einem Modul für eine Messeinrichtung zur Aufnahme von Messparametern des Stromnetzes;
- einem Modul für eine Zeitmesseinrichtung zur Aufnahme einer Zeitmessung und Zuordnung zu den aufgenommenen Messparametern;
- einem Modul für eine Auswerteeinheit zur Analyse und Bewertung der aufgenommenen Messparameter hinsichtlich eines zulässigen Netzbetriebs bzw. einer Überlastung;
- einem Modul für ein Speichermedium zur Dokumentation der Messparameter inklusive der zugeordneten Zeitmessungen sowie der Auswertungen;
- einem Modul für eine Steuereinheit zur Übermittlung möglicher Netzbetriebsänderungen,
wobei für einen Kurzschlussfall im Stromnetz in der Auswerteeinheit ein Algorithmus zur Ermittlung des überlasteten Abzweigs hinterlegt ist.

13. Modular aufgebauter Kontroller nach Anspruch 12, **dadurch gekennzeichnet, dass** die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs aufnimmt.

14. Modular aufgebauter Kontroller nach Anspruch 12 oder 13, **dadurch gekennzeichnet, dass** die Zeitmesseinrichtung eine Echtzeitmessung ist, welche einen Zeitzwischenraum bestimmt, oder Uhrzeitmessungen, aus welchen der Zeitzwischenraum zu ermitteln ist.

15. Modular aufgebauter Kontroller nach einem der Ansprüche 12 bis 14, **dadurch gekennzeichnet, dass** der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

16. Modular aufgebauter Kontroller nach einem der Ansprüche 12 bis 14, **dadurch gekennzeichnet, dass** der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Abzweigen ist, wobei eine abweichende Vergleichsmessung zum archivierten Messwert an einer bestimmten Stelle im Stromnetz den Kurzschluss auslösenden Abzweig kennzeichnet .

17. Modular aufgebauter Kontroller nach einem der Ansprüche 12 bis 14, **dadurch gekennzeichnet, dass** der Algorithmus zur Ermittlung des überlasteten Abzweigs im Stromnetz in Form einer Fuzzy-Logik ausgebildet ist.

18. Modular aufgebauter Kontroller nach einem der Ansprüche 12 bis 14, **dadurch gekennzeichnet, dass** der Algorithmus zur Ermittlung des überlasteten Abzweigs im Stromnetz als Priorisierung nach der Wahrscheinlichkeit innerhalb einer Fuzzy-Logik ausgebildet ist.

19. Modular aufgebauter Kontroller nach einem der Ansprüche 15 bis 18, **dadurch gekennzeichnet, dass** für einen optimierten Stromnetzbetrieb eine Priorisierung der unterschiedlichen zur Anwendung zu bringenden Algorithmen in der Auswerteeinheit des integrierten Kontrollers hinterlegt ist.

20. Modular aufgebauter Kontroller nach Anspruch 19, **dadurch gekennzeichnet, dass** eine Priorisierung der Algorithmen auf einer Auswertung von Erfahrungswerten basierend ausgebildet ist und in Form einer Teach-In-Funktion in die Auswerteeinheit zu integrieren ist.

21. Modular aufgebauter Kontroller nach einem der Ansprüche 12 bis 20, **dadurch gekennzeichnet, dass** in der Steuereinheit eine Auslösekennlinie für eine Überlastung hinterlegt ist, welche einen Abschaltvorgang im Lastabzweig auslöst.

22. Modular aufgebauter Kontroller nach einem der Ansprüche 12 bis 21, **dadurch gekennzeichnet, dass** der modular aufgebaute Kontroller eine Kommunikationsschnittstelle aufweist, welche eine Anbindung an eine Cloud oder ein anderes externes oder internes Medium bzw. eine Auswerteeinheit ermöglicht.

23. Digitaler DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle nachfolgenden Funktionseinheiten kompakt in einem Gerät umfasst, oder mit einem modular aufgebauten Kontroller, wobei der modular aufgebaute Kontroller ein- oder mehrmodulare separat austauschbare Module aufweist, umfassend:
- eine Messeinrichtung zur Aufnahme von Messparametern des Stromnetzes modular oder integriert ausgeführt;
- eine Zeitmesseinrichtung zur Aufnahme einer Zeitmessung und Zuordnung zu den aufgenommenen Messparametern modular oder integriert ausgeführt;
- eine Auswerteeinheit zur Analyse und Bewertung der aufgenommenen Messparameter hinsichtlich eines zulässigen Netzbetriebs bzw. einer Überlastung modular oder integriert ausgeführt;
- ein Speichermedium zur Dokumentation der Messparameter inklusive der zugeordneten Zeitmessungen sowie der Auswertungen modular oder integriert ausgeführt;
- eine Steuereinheit zur Übermittlung möglicher Netzbetriebsänderungen modular oder integriert ausgeführt,
wobei für einen Kurzschlussfall im Stromnetz in der Auswerteeinheit ein Algorithmus zur Ermittlung des überlasteten Abzweigs hinterlegt ist.

24. Digitaler DC-Schalter nach Anspruch 23, **dadurch gekennzeichnet, dass** die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs aufnimmt.

25. Digitaler DC-Schalter nach Anspruch 23 oder 24, **dadurch gekennzeichnet, dass** die Zeitmesseinrichtung eine Echtzeitmessung ist, welche einen Zeitzwischenraum bestimmt, oder Uhrzeitmessungen, aus welchen der Zeitzwischenraum zu ermitteln ist.

26. Digitaler DC-Schalter nach einem der Ansprüche 23 bis 25, **dadurch gekennzeichnet, dass** der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

27. Digitaler DC-Schalter nach einem der Ansprüche 23 bis 25, **dadurch gekennzeichnet, dass** der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Abzweigen ist, wobei eine abweichende Vergleichsmessung zum archivierten Messwert an einer bestimmten Stelle im Stromnetz den Kurzschluss auslösenden Abzweig kennzeichnet.

28. Digitaler DC-Schalter nach einem der Ansprüche 23 bis 25, **dadurch gekennzeichnet, dass** der Algorithmus zur Ermittlung des überlasteten Abzweigs im Stromnetz in Form einer Fuzzy-Logik ausgebildet ist.

29. Digitaler DC-Schalter nach einem der Ansprüche 23 bis 25, **dadurch gekennzeichnet, dass** der Algorithmus zur Ermittlung des überlasteten Abzweigs im Stromnetz als Priorisierung nach der Wahrscheinlichkeit innerhalb einer Fuzzy-Logik ausgebildet ist.

30. Digitaler DC-Schalter nach einem der Ansprüche 26 bis 29, **dadurch gekennzeichnet, dass** für einen optimierten Stromnetzbetrieb eine Priorisierung der unterschiedlichen zur Anwendung zu bringenden Algorithmen in der Auswerteeinheit des integrierten Kontrollers hinterlegt ist.

31. Digitaler DC-Schalter nach Anspruch 30, **dadurch gekennzeichnet, dass** eine Priorisierung der Algorithmen auf einer Auswertung von Erfahrungswerten basierend ausgebildet ist und in Form einer Teach-In-Funktion in die Auswerteeinheit zu integrieren ist.

32. Digitaler DC-Schalter nach einem der Ansprüche 23 bis 31, **dadurch gekennzeichnet, dass** in der Steuereinheit eine Auslösekennlinie für eine Überlastung hinterlegt ist, welche einen Abschaltvorgang im Abzweig auslöst.

33. Digitaler DC-Schalter nach einem der Ansprüche 23 bis 32, **dadurch gekennzeichnet, dass** der integrierte oder modular aufgebaute Kontroller eine Kommunikationsschnittstelle aufweist, welche eine Anbindung an eine Cloud oder ein anderes externes oder internes Medium bzw. eine Auswerteeinheit ermöglicht.

34. Stromverteilungsnetz mit einem digitalen DC-Schalter für einen optimierten Stromnetzbetrieb eines aus einem Wechselspannungs- oder Gleichspannungsnetz generierten Gleichspannungsnetzes oder Hybridnetzes mit einem integrierten Kontroller, wobei der integrierte Kontroller alle nachfolgenden Funktionseinheiten kompakt in einem Gerät umfasst, oder mit einem modular aufgebauten Kontroller, wobei der modular aufgebaute Kontroller ein- oder mehrmodulare separat austauschbare Module aufweist, umfassend:
- eine Messeinrichtung zur Aufnahme von Messparametern des Stromnetzes modular oder integriert ausgeführt;
- eine Zeitmesseinrichtung zur Aufnahme einer Zeitmessung und Zuordnung zu den aufgenommenen Messparametern modular oder integriert ausgeführt;
- eine Auswerteeinheit zur Analyse und Bewertung der aufgenommenen Messparameter hinsichtlich eines zulässigen Netzbetriebs bzw. einer Überlastung modular oder integriert ausgeführt;
- ein Speichermedium zur Dokumentation der Messparameter inklusive der zugeordneten Zeitmessungen sowie der Auswertungen modular oder integriert ausgeführt;
- eine Steuereinheit zur Übermittlung möglicher Netzbetriebsänderungen modular oder integriert ausgeführt,
wobei für einen Kurzschlussfall im Stromnetz in der Auswerteeinheit ein Algorithmus zur Ermittlung des überlasteten Abzweigs hinterlegt ist.

35. Stromverteilungsnetz nach Anspruch 34, **dadurch gekennzeichnet, dass** die Messeinrichtung Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs aufnimmt.

36. Stromverteilungsnetz nach Anspruch 34 oder 35, **dadurch gekennzeichnet, dass** die Zeitmesseinrichtung eine Echtzeitmessung ist, welche einen Zeitzwischenraum bestimmt, oder Uhrzeitmessungen, aus welchen der Zeitzwischenraum zu ermitteln ist.

37. Stromverteilungsnetz nach einem der Ansprüche 34 bis 36, **dadurch gekennzeichnet, dass** der Algorithmus zur Ermittlung des überlasteten Abzweigs im Stromnetz im ersten Schritt eine Messung zumindest eines Messparameters an Knotenpunkten im Stromnetz ist, an welchen zumindest ein Abzweig zugeschaltet ist, welche mit dem Messwert eines zuvor hinterlegten Messdurchgangs verglichen wird, wobei in den zugehörigen Abzweigen des Knotenpunkts mit einer abweichenden Messung zum vorherigen Messdurchgang im zweiten Schritt weiterführende Messungen durchgeführt werden.

38. Stromverteilungsnetz nach einem der Ansprüche 34 bis 36, **dadurch gekennzeichnet, dass** der Algorithmus zur Ermittlung des überlasteten Abzweigs im Stromnetz eine vergleichende Einzelanalyse aller zugeschalteter Abzweige mit bereits im Speichermedium archivierten Messpunkten zu den jeweiligen Abzweigen ist, wobei eine abweichende Vergleichsmessung zum archivierten Messwert an einer bestimmten Stelle im Stromnetz den Kurzschluss auslösenden Abzweig kennzeichnet.

39. Stromverteilungsnetz nach einem der Ansprüche 34 bis 36, **dadurch gekennzeichnet, dass** der Algorithmus zur Ermittlung des überlasteten Abzweigs im Stromnetz in Form einer Fuzzy-Logik ausgebildet ist.

40. Stromverteilungsnetz nach einem der Ansprüche 34 bis 36, **dadurch gekennzeichnet, dass** der Algorithmus zur Ermittlung des überlasteten Abzweigs im Stromnetz als Priorisierung nach der Wahrscheinlichkeit innerhalb einer Fuzzy-Logik ausgebildet ist.

41. Stromverteilungsnetz nach einem der Ansprüche 37 bis 40, **dadurch gekennzeichnet, dass** für einen optimierten Stromnetzbetrieb eine Priorisierung der unterschiedlichen zur Anwendung zu bringenden Algorithmen in der Auswerteeinheit des Kontrollers hinterlegt ist.

42. Stromverteilungsnetz nach Anspruch 41, **dadurch gekennzeichnet, dass** eine Priorisierung der Algorithmen auf einer Auswertung von Erfahrungswerten basierend ausgebildet ist und in Form einer Teach-In-Funktion in die Auswerteeinheit des Kontrollers zu integrieren ist.

43. Stromverteilungsnetz nach einem der Ansprüche 34 bis 42, **dadurch gekennzeichnet, dass** in der Steuereinheit eine Auslösekennlinie für eine Überlastung hinterlegt ist, welche einen Abschaltvorgang im Abzweig auslöst.

44. Stromverteilungsnetz nach einem der Ansprüche 34 bis 43, **dadurch gekennzeichnet, dass** der integrierte oder modular aufgebaute Kontroller eine Kommunikationsschnittstelle aufweist, welche eine Anbindung an eine Cloud oder ein anderes externes oder internes Medium bzw. eine Auswerteeinheit ermöglicht.

45. Computerprogrammprodukt für einen optimierten Stromnetzbetrieb eines aus einem Wechselspannungs- oder Gleichspannungsnetz generierten Gleichspannungsnetzes oder Hybridnetzes, welches auf einem Medium mit einer funktionalen Ausrichtung als Computer gespeichert ist und mediumlesbare Programmittel aufweist, welche das Medium dazu veranlassen, ermittelte Messparameter des Stromnetzes auszuwerten und hinsichtlich eines zulässigen Netzbetriebs bzw. einer Überlastung zu bewerten, wobei für einen Kurzschlussfall im Stromnetz ein Algorithmus zur Ermittlung des überlasteten Abzweigs durchgeführt wird.

46. Computerprogrammprodukt nach Anspruch 45, **dadurch gekennzeichnet, dass** das Computerprogrammprodukt mediumlesbare Programmittel aufweist, welche das Medium dazu veranlassen, zur Ermittlung des überlasteten Abzweigs im Stromnetz einen Algorithmus in Form einer Fuzzy-Logik zu durchlaufen.

47. Computerprogrammprodukt nach Anspruch 45, **dadurch gekennzeichnet, dass** das Computerprogrammprodukt mediumlesbare Programmittel aufweist, welche das Medium dazu veranlassen, einen Algorithmus zur Ermittlung des überlasteten Abzweigs im Stromnetz auf Basis einer vergleichenden Einzelanalyse aller zugeschalteter Abzweige mit bereits im Speichermedium archivierten Messpunkten zu den jeweiligen Abzweigen zu durchlaufen, wobei eine abweichende Vergleichsmessung zum archivierten Messwert an einer bestimmten Stelle im Stromnetz den Kurzschluss auslösenden Abzweig kennzeichnet.

48. Computerprogrammprodukt nach Anspruch 45, **dadurch gekennzeichnet, dass** das Computerprogrammprodukt mediumlesbare Programmittel aufweist, welche das Medium dazu veranlassen, einen Algorithmus zur Ermittlung des überlasteten Abzweigs im Stromnetz in Form einer Priorisierung nach der Wahrscheinlichkeit innerhalb einer Fuzzy-Logik zu durchlaufen.

49. Computerprogrammprodukt nach einem der Ansprüche 45 bis 48, **dadurch gekennzeichnet, dass** das Computerprogrammprodukt mediumlesbare Programmittel aufweist, welche das Medium dazu veranlassen, für einen optimierten Stromnetzbetrieb eine Priorisierung der unterschiedlichen zur Anwendung zu bringenden Algorithmen zu ermitteln.

50. Verfahren für einen optimierten Stromnetzbetrieb eines aus einem Wechselspannungs- oder Gleichspannungsnetz generierten Gleichspannungsnetzes oder Hybridnetzes mittels eines integrierten Kontrollers, wobei der integrierte Kontroller alle nachfolgenden Funktionseinheiten kompakt in einem Gerät umfasst, oder mittels eines modular aufgebauten Kontrollers, wobei der modular aufgebaute Kontroller ein- oder mehrmodulare separat austauschbare Module aufweist, mit den Schritten:
- Messen von Messparametern des Stromnetzes mittels einer Messeinrichtung des modular aufgebauten oder integrierten Kontrollers;
- Messen der Zeit und zuordnen der Zeitmesswerte zu den aufgenommenen Messparametern mittels einer Zeitmesseinrichtung des modular aufgebauten oder integrierten Kontrollers;
- Auswerten und bewerten der aufgenommenen Messparameter hinsichtlich eines zulässigen Netzbetriebs bzw. einer Überlastung mittels einer Auswerteeinheit des modular aufgebauten oder integrierten Kontrollers;
- Speichern der Messparameter inklusive der zugeordneten Zeitmessungen sowie der ausgewerteten Messdurchgänge zur Dokumentation mittels eines Speichermediums des modular aufgebauten oder integrierten Kontrollers;
- Aussteuern möglicher Netzbetriebsänderungen mittels einer Steuereinheit des modular aufgebauten oder integrierten Kontrollers,
wobei für einen Kurzschlussfall im Stromnetz ein Algorithmus zur Ermittlung des überlasteten Abzweigs durchgeführt wird.

51. Verfahren nach Anspruch 50, **dadurch gekennzeichnet, dass** als Messparameter für das Stromnetz Strommesswerte und/oder Spannungswerte und/oder die Leistung betreffende Werte und/oder die Temperatur in einem im Abzweig integrierten, stromführenden Stromkreiselement und/oder die Anzahl der Schaltzyklen eines zuzuschaltenden Abzweigs ermittelt werden.

52. Verfahren nach Anspruch 50 oder 51, **dadurch gekennzeichnet, dass** die Zeitmessung als Echtzeitmessung, welche einen Zeitzwischenraum bestimmt, oder in Form von Uhrzeitmessungen durchgeführt wird, aus welchen der Zeitzwischenraum ermittelt wird.

53. Verfahren nach einem der Ansprüche 50 bis 52, **dadurch gekennzeichnet, dass** der Algorithmus zur Ermittlung des überlasteten Abzweigs im Stromnetz im ersten Schritt als Messung zumindest eines Messparameters an Knotenpunkten im Stromnetz durchgeführt wird, an welchen zumindest ein Abzweig zugeschaltet ist, welche mit dem Messwert eines zuvor hinterlegten Messdurchgangs verglichen wird, und dass im zweiten Schritt in den zugehörigen Abzweigen dieses Knotenpunkts mit einer abweichenden Messung zum vorherigen Messdurchgang weiterführende Messungen durchgeführt werden.

54. Verfahren nach einem der Ansprüche 50 bis 52, **dadurch gekennzeichnet, dass** der Algorithmus zur Ermittlung des überlasteten Abzweigs im Stromnetz als vergleichende Einzelanalyse aller zugeschalteter Abzweige mit bereits im Speichermedium archivierten Messpunkten zu den jeweiligen Abzweigen durchgeführt wird, wobei eine abweichende Vergleichsmessung zum archivierten Messwert an einer bestimmten Stelle im Stromnetz den Kurzschluss auslösenden Abzweig kennzeichnet.

55. Verfahren nach einem der Ansprüche 50 bis 52, **dadurch gekennzeichnet, dass** der Algorithmus zur Ermittlung des überlasteten Abzweigs im Stromnetz in Form einer Fuzzy-Logik durchgeführt wird.

56. Verfahren nach einem der Ansprüche 50 bis 52, **dadurch gekennzeichnet, dass** der Algorithmus zur Ermittlung des überlasteten Abzweigs im Stromnetz als Priorisierung nach der Wahrscheinlichkeit innerhalb einer Fuzzy-Logik durchgeführt wird.

57. Verfahren nach Anspruch 56, **dadurch gekennzeichnet, dass** die Priorisierung der Algorithmen auf einer Auswertung von Erfahrungswerten basierend durchgeführt wird und in Form einer Teach-In-Funktion auf die Auswerteeinheit eingespielt wird.

58. Verfahren nach einem der Ansprüche 50 bis 57, **dadurch gekennzeichnet, dass** durch eine Auslösekennlinie in der Steuereinheit, welche eine Überlastung kennzeichnet, ein Abschaltvorgang im Abzweig ausgelöst wird.

59. Verwendung eines integrierten Kontrollers gemäß der Ansprüche 1 bis 11, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, oder eines modular aufgebauten Kontrollers gemäß der Ansprüche 12 bis 22, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes in einem digitalen DC-Schalter gemäß der Ansprüche 23 bis 33 und mittels des digitalen DC-Schalters in einem Stromverteilungsnetz gemäß der Ansprüche 34 bis 44 in einer Automatisierungsanlage.

60. Verwendung eines integrierten Kontrollers gemäß der Ansprüche 1 bis 11, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, oder eines modular aufgebauten Kontrollers gemäß der Ansprüche 12 bis 22, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes in einem digitalen DC-Schalter gemäß der Ansprüche 23 bis 33 und mittels des digitalen DC-Schalters in einem Stromverteilungsnetz gemäß der Ansprüche 34 bis 44 in der Antriebstechnik.

61. Verwendung eines integrierten Kontrollers gemäß der Ansprüche 1 bis 11, wobei der integrierte Kontroller alle Funktionseinheiten kompakt in einem Gerät umfasst, für einen optimierten Stromnetzbetrieb eines aus einem Wechselspannungs- oder Gleichspannungsnetz generierten Gleichspannungsnetzes oder Hybridnetzes, oder eines modular aufgebauten Kontrollers gemäß der Ansprüche 12 bis 22, wobei der modular aufgebaute Kontroller ein- oder mehrmodulare separat austauschbare Module aufweist, für einen optimierten Stromnetzbetrieb eines aus einem Wechselspannungs- oder Gleichspannungsnetz generierten Gleichspannungsnetzes oder Hybridnetzes in einem digitalen DC-Schalter gemäß der Ansprüche 23 bis 33 und mittels des digitalen DC-Schalters in einem Stromverteilungsnetz gemäß der Ansprüche 34 bis 44 in der Leistungselektronik.

62. Verwendung eines Computerprogrammprodukts für einen optimierten Stromnetzbetrieb eines aus einem Wechselspannungsoder Gleichspannungsnetz generierten Gleichspannungsnetzes oder Hybridnetzes nach den Ansprüchen 45 bis 49 in einer Automatisierungsanlage.

63. Verwendung eines Computerprogrammprodukts für einen optimierten Stromnetzbetrieb eines aus einem Wechselspannungsoder Gleichspannungsnetz generierten Gleichspannungsnetzes oder Hybridnetzes nach den Ansprüchen 45 bis 49 in der Antriebstechnik.

64. Verwendung eines Computerprogrammprodukts für einen optimierten Stromnetzbetrieb eines aus einem Wechselspannungsoder Gleichspannungsnetz generierten Gleichspannungsnetzes oder Hybridnetzes nach den Ansprüchen 45 bis 49 in der Leistungselektronik.
